# EUROPEAN PATENT APPLICATION

(11) **EP 3 148 018 A1**
(43) Date of publication of application: **29.03.2017**
(21) Application number: 15306495.1
(22) Date of filing: 25.09.2015
(51) Int. Cl.: H01S 5/0683, H01S 5/40, H01S 5/50, H04B 10/291, H01S 5/00, H01S 5/022, H01S 5/06, H04B 10/293

(54) **AMPLIFICATION DEVICE WITH POLARIZED SOAS, FOR AMPLIFYING OPTICAL SIGNALS IN A WDM TRANSMISSION SYSTEM**

(71) Applicant: ALCATEL LUCENT, 92100 Boulogne-Billancourt (FR)
(72) Inventor: RENAUDIER, Jérémie, 91620 NOZAY (FR); BRENOT, Romain, 91620 NOZAY (FR); CHARLET, Gabriel, 91620 NOZAY (FR)
(74) Representative: Novagraaf Technologies

(57) **Abstract**

An amplification device (1) comprises:
- a splitting element (2) arranged for splitting an input optical signal in first and second optical signals having respectively first and second polarization modes,
- first (3) and second (4) polarized semiconductor optical amplifiers arranged for amplifying respectively the first and second optical signals as a function of first and second driving currents,
- a combination element (5) arranged for combining the first and second amplified optical signals to produce an output optical signal, and
- a control means (6) arranged for producing the first and second driving currents as a function of information representative of powers of at least the first and second optical signals before the first (3) and second (4) polarized semiconductor optical amplifiers and of a targeted power of the output optical signal. The splitter and combiner may be polarizers and additional half-wave plates (15,16) may adjust the desired polarisation. Micro-lenses (11-14) may be used for focusing and collimation of the beams around the SOA (3,4). The signals sensed with the photodetectors (19,20,23,24) may be compared with numbers of a look-up table to determine the bias currents of the SOA.

## Description

### Field of the Invention

The present invention relates to Wavelength Division Multiplexing (or WDM) transmission systems, and more precisely to amplification devices arranged for amplifying optical signals in such WDM transmission systems.

### Background

As known by those skilled in the art, in WDM transmission systems, increasing capacity in an optical fiber link at unchanged amplification bandwidth requires to increase the spectral efficiency.

To get such an increase, it is possible to use complex modulation formats. This allows to go beyond the spectral efficiency of polarization division multiplexed (or PDM) quaternary phase shifted keying (or QPSK), but at the expense of strongly reduced transmission distances.

It is also possible to reduce the channel spacing thanks to the use of orthogonal frequency-division multiplexing (or OFDM) or Nyquist pulse shaping techniques. But this solution must be limited to a channel spacing equal to the symbol rate in order to avoid drastic linear crosstalk issue.

But, it is also possible to increase the optical bandwidth. Unfortunately, most of the current WDM transmission systems use erbium doped fiber amplifiers (or EDFAs) whose optical bandwidth appears to be limited to a maximum of 5 THz (~40nm) since almost fifteen years. Therefore the optical bandwidth of EDFAs is nowadays a limiting factor to the continuous increase of WDM transmission system capacity.

It could be possible to replace the EDFAs by amplifiers making use of Raman amplification. However, this solution has not met a large commercial success because it requires some complex management. Indeed, it is not adequate to compensation of lumped losses (like those induced by reconfigurable optical add-drop multiplexers (or ROADMs). Moreover, a double Rayleigh backscattering appears when the gain becomes higher than 20 dB, and the risk of connector burning out is high.

### Summary

So an object of this invention is to improve the situation, and notably to allow increasing the optical bandwidth in WDM transmission systems.

In an embodiment, an amplification device comprises:
- a splitting element arranged for splitting an input optical signal in first and second optical signals having respectively first and second polarization modes,
- first and second polarized semiconductor optical amplifiers (or SOAs) arranged for amplifying respectively the first and second optical signals as a function of first and second driving currents,
- a combination element arranged for combining the first and second amplified optical signals to produce an output optical signal, and
- a control means arranged for producing these first and second driving currents as a function of information representative of powers of at least the first and second optical signals before the first and second polarized semiconductor optical amplifiers and of a targeted power of the output optical signal.

The amplification device may include additional characteristics considered separately or combined, and notably:
- its first and second polarized semiconductor optical amplifiers may be arranged for amplifying optical signals having the first polarization mode. In this case, it may further comprise a first transformation element arranged for tansforming the second polarization mode of the second optical signal in the first polarization mode before the second polarized semiconductor optical amplifier, and a second transformation element arranged for tansforming the first polarization mode of the first optical signal in the second polarization mode after the first polarized semiconductor optical amplifier, so that the combination element combines the first optical signal amplified and having the second polarization mode with the second optical signal amplified and having the first polarization mode to produce the output optical signal;
- the first transformation element and/or the second transformation element may comprise a waveplate;
- it may further comprise first and second micro-lenses located respectively just before and just after the first polarized semiconductor optical amplifier, and third and fourth micro-lenses located respectively just before and just after the second polarized semiconductor optical amplifier;
- it may further comprise a first extracting element arranged for taking a first predefined percentage of the power of the first optical signal before the first polarized semiconductor optical amplifier, a first photodiode arranged for producing a first information representative of the power taken from the first optical signal before the first polarized semiconductor optical amplifier for the control means, a second extracting element arranged for taking a second predefined percentage of the power of the second optical signal before the second polarized semiconductor optical amplifier, and a second photodiode arranged for producing a second information representative of the power taken from the second optical signal before the second polarized semiconductor optical amplifier for the control means;
- its control means may be arranged for producing the first and second driving currents as a function of information representative of powers of the first and second optical signals before and after the first and second polarized semiconductor optical amplifiers and of the targeted power of the output optical signal;
- it may further comprise a third extracting element arranged for taking a third predefined percentage of the power of the first optical signal after the first polarized semiconductor optical amplifier, a third photodiode arranged for producing a third information representative of the power taken from the first optical signal after the first polarized semiconductor optical amplifier for the control means, a fourth extracting element arranged for taking a fourth predefined percentage of the power of the second optical signal after the second polarized semiconductor optical amplifier, and a fourth photodiode arranged for producing a fourth information representative of the power taken from the second optical signal after the second polarized semiconductor optical amplifier for the control means;

- the first polarization mode may be a transverse electric mode and the second polarization mode may be a transverse magnetic mode;
- its splitting element and/or its combination element may comprise a birefringent material;
- its control means may be arranged for determining the first and second driving currents from stored data establishing a correspondence between information representative of powers and driving currents.

### Brief Description of the Figures

Some embodiments of an amplification device in accordance with embodiments of the present invention are now described, by way of example only, and with reference to the accompanying drawings, in which:
- Figure 1 schematically and functionally illustrates an example of embodiment of an amplification device according to the invention; and
- Figure 2 schematically illustrates in a diagram an example of evolution of the optical power outputted by a polarized SOA as a function of the wavelength in nanometer (nm).

### Description of Embodiments

Hereafter is notably disclosed an amplification device 1 intended for amplifying input optical signals in a Wavelength Division Multiplexing (or WDM) transmission system.

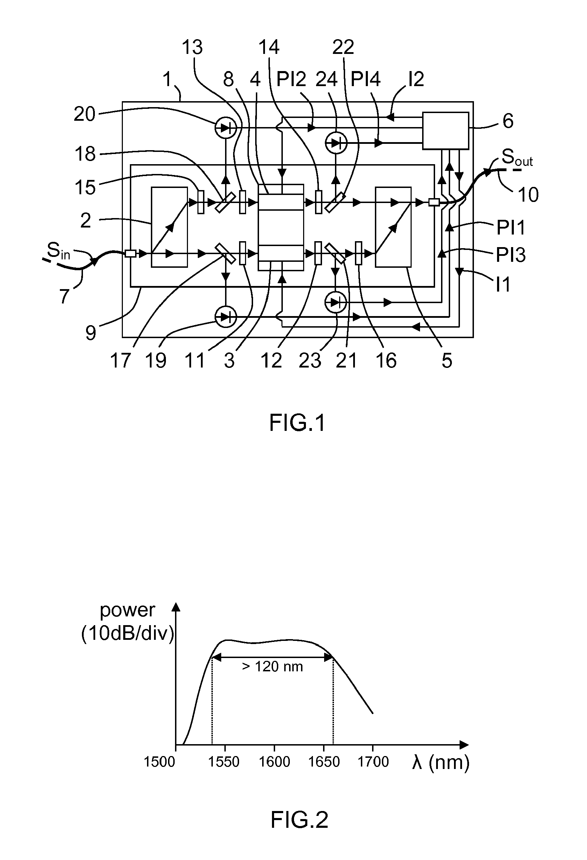

As illustrated in Figure 1, an amplification device 1 according to the invention comprises at least a splitting element 2, first 3 and second 4 polarized semiconductor optical amplifiers (or SOAs), a combination element 5, and a control means 6.

The splitting element 2 is arranged (or configured) for splitting an input optical signal Sᵢₙ in first and second optical signals having respectively first and second polarization modes. As illustrated, this input optical signal Sᵢₙ is provided by a first optical fiber link 7 of a WDM transmission system, which is connected to an input of the amplification device 1.

For instance, the splitting element 2 may comprise a birefringent material that is capable of physically splitting the input optical signal Sᵢₙ in first and second optical signals in order to deliver them respectively onto distant first and second outputs. For instance, the birefringent material may be a crystal quartz or a calcite crystal.

Also for instance, the first polarization mode may be a transverse electric (or TE) mode and the second polarization mode may be a transverse magnetic (or TM) mode. But the reverse situation may be envisaged (i.e. a first polarization mode that is a TM mode and a second polarization mode that is a TE mode) if the amplifier is designed and/or positioned to amplify TM mode.

The first polarized semiconductor optical amplifier (or SOA) 3 is arranged for amplifying the first optical signal (originating from a first output of the splitting element 2) as a function of a first driving current 11 provided by the control means 6.

The second polarized semiconductor optical amplifier (or SOA) 4 is arranged for amplifying the second optical signal (originating from a second output of the splitting element 2) as a function of a second driving current 12 provided by the control means 6.

One means here by "polarized SOA" a SOA arranged for optimally amplifying an optical signal having a predefined polarization mode. This type of SOA, optimized for a predefined polarization mode, may be designed to exhibit a very large gain bandwidth.

The diagram of Figure 2 illustrates an example of evolution of the optical power outputted by a polarized SOA with a very large gain bandwidth as a function of the wavelength in nanometer (nm). In this example the gain bandwidth is larger than 120 nm, which represents a threefold increase of optical gain bandwidth with respect to commonly used EDFAs.

For instance, and as illustrated in the non-limiting example of Figure 1, the first 3 and second 4 SOAs may be two sub-parts of an integrated component 8 that is secured to a small plate (or board) 9.

The combination element 5 is arranged for combining the first and second amplified optical signals (originating respectively from the first 3 and second 4 SOAs) to produce an output optical signal Sₒᵤₜ. As illustrated, this output optical signal Sₒᵤₜ feeds a second optical fiber link 10 of the WDM transmission system, which is connected to an output of the amplification device 1.

For instance, the combination element 5 may comprise a birefringent material that is capable of combining the first and second amplified optical signals it receives onto distant first and second inputs in order to deliver an output optical signal Sₒᵤₜ. For instance, the birefringent material may be a crystal quartz or a calcite crystal.

Also for instance, and as illustrated, the splitting element 2 and the combination element 5 (that performs a "reverse splitting") may be secured to the small plate (or board) 9 or to a subsidiary plate.

Preferably and as illustrated, there is a free space between each output of the splitting element 2 and the corresponding polarized SOA 3 or 4, but also between the output of each polarized SOA 3 or 4 and the corresponding input of the combination element 5. The reason of that will appear below. When these free spaces are defined, the amplification device 1 preferably comprises further a first micro-lens 11 located just before the first polarized SOA 3, a second micro-lens 12 located just after the first polarized SOA 3, a third micro-lens 13 located just before the second polarized SOA 4, and a fourth micro-lens 14 located just after the second polarized SOA 4. These micro-lenses 11-14 allow improving light coupling between elements.

For instance, and as illustrated, the micro-lenses 11-14 may be secured to the small plate (or board) 9 or to a subsidiary plate.

The control means 6 is arranged for producing the first 11 and second 12 driving currents as a function of information representative of powers of at least the first and second optical signals before the first 3 and second 4 polarized SOAs and of a targeted power of the output optical signal Sₒᵤₜ. So, it aims at controlling automatically the respective amplification levels of the first 3 and second 4 polarized SOAs so that the output optical signal Sₒᵤₜ be approximately equal to the targeted power (i.e. equal to the latter with a predefined tolerance).

The control means 6 is preferably made of a combination of hardware and software modules, by means of a microcontroller or a central processing unit (or CPU), for instance.

To ease practical implementation, the first 3 and second 4 polarized SOAs are preferably arranged for amplifying optical signals having the first polarization mode (and preferably the TE mode). In this embodiment, the amplification device 1 must further comprise first 15 and second 16 transformation elements to allow a combination of first and second optical signals with different polarization modes by the combination element 5, as illustrated in the non-limiting example of Figure 1.

The first transformation element 15 is arranged for tansforming the second polarization mode of the second optical signal (provided by the second output of the splitting element 2) in the first polarization mode. So, it is located before the second polarized SOA 4. It should be understood that this transformation consists in a rotation from the second polarization mode to the first polarization mode.

The second transformation element 16 is arranged for tansforming the first polarization mode of the first optical signal (provided by the output of the first SOA 3) in the second polarization mode. So, it is located after the first polarized SOA 3. It should be understood that this transformation consists in a rotation from the first polarization mode to the second polarization mode.

Such an embodiment allows the combination element 5 to combine the first optical signal (amplified and having the second polarization mode) with the second optical signal (amplified and having the first polarization mode) to produce the output optical signal Sₒᵤₜ.

For instance, the first transformation element 15 and/or the second transformation element 16 comprise(s) a waveplate arranged for inducing the above mentioned polarization mode rotations. These waveplates may be used when the above mentioned free spaces are defined.

The non-limiting embodiment described above, with reference to Figure 1, allows defining two equivalent optical paths, respectively for the first and second optical signals. This allows the control means 6 to automatically equalize the powers outputted respectively by these two optical paths and feeding respectively the first and second inputs of the combination element 5.

In order the control means 6 be informed of the respective powers of the first and second optical signals before the first 3 and second 4 SOAs, the amplification device 1 may comprise first 17 and second 18 extracting elements and first 19 and second 20 photodiodes.

The first extracting element 17 is arranged for taking a first predefined percentage of the power of the first optical signal before the first polarized SOA 3. The first photodiode 19 is arranged for producing a first information PI1 representative of the power taken from the first optical signal before the first polarized SOA 3 for the control means 6. The second extracting element 18 is arranged for taking a second predefined percentage of the power of the second optical signal before the second polarized SOA 4. The second photodiode 20 is arranged for producing a second information PI2 representative of the power taken from the second optical signal before the second polarized SOA 4 for the control means 6.

For instance, the first and second predefined percentages may be equal to 1 %. But other values may be used.

Also for instance, the first 17 and second 18 extracting elements may each comprise a tap coupler arranged for reflecting the first or second predefined power percentage of the first or second optical signal, and of transmitting the complementary power percentage of the first or second optical signal. In the case where the first or second predefined percentage is equal to 1%, the complementary power percentage is equal to 99%.

Also for instance, the first 17 and second 18 extracting elements may be beamsplitters, such as semi-reflective plates or partially reflective mirrors. These beamsplitters may be used when the above mentioned free spaces are defined.

Also for instance, and as illustrated, the first 17 and second 18 extracting elements may be secured to the small plate (or board) 9. The first 19 and second 20 photodiodes may be secured to the same small plate 9 or to a subsidiary plate positioned below the first one.

Also for instance, the first 19 and second 20 photodiodes may exhibit a low bandwidth.

To improve the power equalization on the two optical paths, the control means 6 may be advantageously arranged for producing the first I1 and second I2 driving currents as a function also of other information representative of powers of the first and second optical signals after the first 3 and second 4 polarized SOAs.

In order the control means 6 be informed of the respective powers of the first and second optical signals after the first 3 and second 4 SOAs, the amplification device 1 may comprise third 21 and fourth 22 extracting elements and third 23 and fourth 24 photodiodes.

The third extracting element 21 is arranged for taking a third predefined percentage of the power of the first optical signal after the first polarized SOA 3. The third photodiode 23 is arranged for producing a third information PI3 representative of the power taken from the first optical signal after the first polarized SOA 3 for the control means 6. The fourth extracting element 22 is arranged for taking a fourth predefined percentage of the power of the second optical signal after the second polarized SOA 4. The fourth photodiode 24 is arranged for producing a fourth information representative of the power taken from the second optical signal after the second polarized SOA 4 for the control means 6.

For instance, the third and fourth predefined percentages may be equal to 1 %. But other values may be used.

Also for instance, the third 21 and fourth 22 extracting elements may each comprise a tap coupler arranged for reflecting the third or fourth predefined power percentage of the first or second amplified optical signal, and of transmitting the complementary power percentage of the first or second amplified optical signal. In the case where the first or second predefined percentage is equal to 1%, the complementary power percentage is equal to 99%.

Also for instance, the third 21 and fourth 22 extracting elements may be beamsplitters, such as semi-reflective plates or partially reflective mirrors. These beamsplitters may be used when the above mentioned free spaces are defined.

Also for instance, and as illustrated, the third 21 and fourth 22 extracting elements may be secured to the small plate (or board) 9. The third 23 and fourth 24 photodiodes may be secured to the same small plate 9 or to a subsidiary plate positioned below the first one.

Also for instance, the third 23 and fourth 24 photodiodes may exhibit a low bandwidth.

The last embodiment allows the control means 6 to precisely balance output powers from the first 3 and second 4 SOAs according to the targeted power of the output optical signal Sₒᵤₜ of the amplification device 1. Once this targeted power is set in the control means 6 through the control plane or a manual setting at startup, each optical path should transmit half of this targeted power. So, the control means 6 adjusts the first I1 and second I2 driving currents accordingly on each SOA 3, 4. To this effect, the control means 6 may, for instance, determine the first I1 and second I2 driving currents from stored data establishing a correspondence between information representative of powers and driving currents.

After having received the power information PI1-PI4 of the two optical paths, the control means 6 finely tunes each driving current I1, I2 to reach the targeted power. To this effect the control means 6 may implement the following algorithm.

Once the control means 6 has received a targeted power associated to a chosen tolerance, it determines in stored data the first I1 and second I2 driving currents corresponding respectively to the last received first PI1 and second PI2 power information and to the targeted power. Then, the control means 6 transmits the determined first I1 and second I2 driving currents respectively to the first 3 and second 4 SOAs.

Then, the control means 6 determines if the difference between half of the targeted power and the third power information PI3 is greater than the tolerance.

In the affirmative, and if half of the targeted power is greater than the third power information PI3, the control means 6 increases the determined first driving current I1 by a chosen value.

But if half of the targeted power is smaller than the third power information PI3, the control means 6 decreases the determined first driving current I1 by a chosen value.

Now, in the negative (i.e. if the difference between half of the targeted power and the third power information PI3 is smaller than the tolerance), the control means 6 maintains the last determined first driving current I1.

In the same way, the control means 6 determines if the difference between half of the targeted power and the fourth power information PI4 is greater than the tolerance.

In the affirmative, and if half of the targeted power is greater than the fourth power information PI4, the control means 6 increases the determined second driving current I2 by a chosen value.

But if half of the targeted power is smaller than the fourth power information PI4, the control means 6 decreases the determined second driving current I2 by a chosen value.

Now, in the negative (i.e. if the difference between half of the targeted power and the fourth power information PI4 is smaller than the tolerance), the control means 6 maintains the last determined second driving current I2.

Thanks to the invention the capacity of a WDM transmission system may be approximately tripled. Moreover, the invention also allows to compensate lumped losses in optical networks by means of simple management rules.

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Amplification device (1) comprising a) a splitting element (2) arranged for splitting an input optical signal in first and second optical signals having respectively first and second polarization modes, b) first (3) and second (4) polarized semiconductor optical amplifiers arranged for amplifying respectively said first and second optical signals as a function of first and second driving currents, c) a combination element (5) arranged for combining said first and second amplified optical signals to produce an output optical signal, and d) a control means (6) arranged for producing said first and second driving currents as a function of information representative of powers of at least said first and second optical signals before said first (3) and second (4) polarized semiconductor optical amplifiers and of a targeted power of said output optical signal.

2. Amplification device according to claim 1, wherein said first (3) and second (4) polarized semiconductor optical amplifiers are arranged for amplifying optical signals having said first polarization mode, and wherein it further comprises a first transformation element (15) arranged for tansforming said second polarization mode of said second optical signal in said first polarization mode before said second polarized semiconductor optical amplifier (4), and a second transformation element (16) arranged for tansforming said first polarization mode of said first optical signal in said second polarization mode after said first polarized semiconductor optical amplifier (3), so that said combination element (5) combines said first optical signal amplified and having said second polarization mode with said second optical signal amplified and having said first polarization mode to produce said output optical signal.

3. Amplification device according to claim 2, wherein said first transformation element (15) and/or said second transformation element (16) comprise(s) a waveplate.

4. Amplification device according to one of claims 1 to 3, wherein it further comprises first (11) and second (12) micro-lenses located respectively just before and just after said first polarized semiconductor optical amplifier (3), and third (13) and fourth (14) micro-lenses located respectively just before and just after said second polarized semiconductor optical amplifier (4).

5. Amplification device according to one of claims 1 to 4, wherein it further comprises a first extracting element (17) arranged for taking a first predefined percentage of the power of said first optical signal before said first polarized semiconductor optical amplifier (3), a first photodiode (19) arranged for producing a first information representative of the power taken from said first optical signal before said first polarized semiconductor optical amplifier (3) for said control means (6), a second extracting element (18) arranged for taking a second predefined percentage of the power of said second optical signal before said second polarized semiconductor optical amplifier (4), and a second photodiode (20) arranged for producing a second information representative of the power taken from said second optical signal before said second polarized semiconductor optical amplifier (4) for said control means (6).

6. Amplification device according to one of claims 1 to 5, wherein said control means (6) is arranged for producing said first and second driving currents as a function of information representative of powers of said first and second optical signals before and after said first (3) and second (4) polarized semiconductor optical amplifiers and of said targeted power of said output optical signal.

7. Amplification device according to claim 6, wherein it further comprises a third extracting element (21) arranged for taking a third predefined percentage of the power of said first optical signal after said first polarized semiconductor optical amplifier (3), a third photodiode (23) arranged for producing a third information representative of the power taken from said first optical signal after said first polarized semiconductor optical amplifier (3) for said control means (6), a fourth extracting element (22) arranged for taking a fourth predefined percentage of the power of said second optical signal after said second polarized semiconductor optical amplifier (4), and a fourth photodiode (24) arranged for producing a fourth information representative of the power taken from said second optical signal after said second polarized semiconductor optical amplifier (4) for said control means (6).

8. Amplification device according to one of claims 1 to 7, wherein said first polarization mode is a transverse electric mode and said second polarization mode is a transverse magnetic mode.

9. Amplification device according to one of claims 1 to 8, wherein said splitting element (2) and/or said combination element (5) comprise(s) a birefringent material.

10. Amplification device according to one of claims 1 to 9, wherein said control means (6) is arranged for determining said first and second driving currents from stored data establishing a correspondence between information representative of powers and driving currents.
